# EUROPEAN PATENT SPECIFICATION

(11) **EP 3 847 418 B1**
(45) Date of publication and mention of the grant of the patent: **12.01.2022**
(21) Application number: 19762804.3
(22) Date of filing: 05.09.2019
(51) Int. Cl.: G01C 25/00, G01C 17/38, G06F 1/16

(54) **METHOD AND SYSTEM FOR CALIBRATING SENSORS**
VERFAHREN UND SYSTEM ZUR KALIBRIERUNG VON SENSOREN
PROCÉDÉ ET SYSTÈME D'ÉTALONNAGE DE CAPTEURS

(30) Priority: 05.09.2018 EP 18398008
(43) Date of publication of application: 14.07.2021
(73) Proprietor: Sword Health, S.A., 4000-437 Porto (PT)
(72) Inventor: PINTO COALHO, Luis Ungaro, 4000-437 Porto (PT); BRANQUIHO GOMES, André, 3810-056 Aveiro (PT); FERREIRA MATOS, Ana Clara, 4000-437 Porto (PT); FERRO BENTO, Virgilio Antonio, 4000-437 Porto (PT)
(74) Representative: Balder IP Law, S.L.
(86) International application number: PCT/EP2019/073694
(87) International publication number: WO 2020/049097

(56) References cited:
- GB-A- 2 553 349
- US-A1- 2013 116 958
- US-A1- 2015 089 823

## Description

### TECHNICAL FIELD

The present invention relates to the field of sensors. More specifically, the present invention relates to methods and system for the calibration of sensors that measure magnetic fields.

### STATE OF THE ART

Sensors are ubiquitous devices that contribute to the automatization of processes or tasks, irrespective of whether said processes or tasks are simple or complex, and also to the decision-making of people. Sensors have thus become a basic device in everyday life.

However, the automatization and decision-making may be negatively influenced when the measurements made by the sensors are not correct. A measurement is correct or not depending on the application and/or the apparatuses involved. Further, in some applications, the sensors, for instance magnetometers, to be used have electronics that do not function accurately or in a stable manner (i.e. the bias thereof increases faster than in sensors having better electronics), so the measurements made have an error that increases over time from the last calibration.

In the technical field of motion tracking, the apparatuses for tracking motion of objects and people use different types of sensors. Some apparatuses use magnetometers for measuring magnetic fields; these sometimes are embodied as MARG sensors. When a plurality of magnetic fields is to be sensed by a plurality of sensors, it is important to measure the magnetic fields without much bias between the measurements, otherwise the motion of the object or person is tracked erroneously.

There are some prior art solutions for calibrating sensors.

Patent document US-20130116958-A1 discloses calibrating sensors integrated into electronic devices, such as a cellular telephone. A base unit (e.g. a dock) includes a sensor calibration function, and when a device having the sensor is coupled to the base unit, the base unit sends sensor calibration parameter to the device.

Patent document GB-2553349-A discloses a method for calibrating one or more sensors of an inertial measurement unit. A dock receives a portable module including the inertial measurement unit, and while the module is docked, the dock calibrates the sensor or sensors of the inertial measurement unit.

Patent document US-20150089823-A1 describes an electronic device having a housing and a compass. Due to manufacturing variations or due to a drop event, the compass may get misaligned with respect to the housing. During operation of the electronic device, control circuity applies calibration data to the readings of the compass so as to electronically attempt to compensate for the misalignment.

These prior art solutions, however, do not assess whether a calibration is necessary and may not even calibrate magnetometers.

Accordingly, it would be advantageous to have a simple and reliable way in which a plurality of sensors having magnetometers may be checked so as to determine the existing differences between the measurements of the different magnetometers provided by the sensors, and also to have a simple and reliable way in which the sensors may be calibrated should the measurements provided have an excessive difference.

### DESCRIPTION OF THE INVENTION

A first aspect of the invention refers to a method for calibrating a plurality of sensors each comprising a magnetometer, a gyroscope and an accelerometer, the method comprising: providing a first device comprising at least one cavity adapted for introduction of one or more sensors, the at least one cavity being dimensioned such that the one or more sensors fit therein when the sensors are introduced with a particular orientation; introducing each sensor of the plurality of sensors into the first device; transmitting, from each sensor of the plurality of sensors to a computing apparatus, a first measure corresponding to the respective magnetometer; determining, the computing apparatus, whether differences between the first measure of each sensor and the first measure of the other sensors of the plurality of sensors are lower than a predetermined threshold; and calibrating the plurality of sensors, if at least one of the differences between the first measures is equal to or greater than the predetermined threshold. In some embodiments, the plurality of sensors is calibrated by rotating the first device with the plurality of sensors introduced therein. In some other embodiments, the plurality of sensors is calibrated by rotating a second device with the plurality of sensors introduced therein, the second device comprising at least one cavity adapted for introduction of one or more sensors.

The method makes possible to verify that each sensor provides a magnetic field measure that does not differ from the magnetic field measure of the other sensors by more than a certain value, and it further makes possible to calibrate the sensors in a simple manner if at least the difference between measures of two sensors exceeds the predetermined threshold. The differences, also referred to in the present disclosure as bias, are between the magnetic field measure (or a component thereof) provided by one sensor and the magnetic field measure (or a component thereof) provided by the other sensor(s) of the plurality of sensors. In this sense, based on the measures provided by the sensors, each possible pair of sensors is compared so as to establish the bias between the magnetic field measure thereof. The predetermined threshold may be established based upon an application in which the sensors are going to be used.

The first device comprises the at least one cavity dimensioned such that one or more sensors fit therein when the sensors are introduced with a particular orientation so that all sensors may be arranged similarly. The at least one cavity may be a single cavity in which two or more sensors may be introduced side-by-side such that the two or more sensors have fixed relative orientations (so that each sensor does not change its orientation with respect to the other sensors); to this end, the single cavity may include one or more spacing elements that provide a gap between each pair of sensors. The at least one cavity may also be a plurality of cavities, in each of which one sensor may be introduced.

The sensors are introduced into the first device so that the verification procedure and, in some embodiments, the calibration procedure as well may take place. Additionally, the first device may also store the sensors when they are not used so that the same external phenomena affect to all sensors similarly. In some other embodiments, the calibration procedure is carried out with the second device after the verification procedure has been carried out with the first device, particularly when the dimensions or weight of the first device are such that make difficult the calibration of the sensors by rotating the first device. Accordingly, the second device may feature dimensions and/or weight that are smaller than that/those of the first device so that rotation of the second device is easier. Thus, in these other embodiments, the second device with a single cavity (in which two or more sensors may be introduced side-by-side such that the two or more sensors have fixed relative orientations) or with a plurality of cavities is also provided, and the sensors are introduced into the second device (i.e. they are moved from the first device to the second device) if it is determined that at least one of the differences between the first measures is equal to or greater than the predetermined threshold.

The sensors transmit the measure(s) corresponding to the respective magnetometers to the computing apparatus, which in turn uses the measure(s) to determine if the sensors are providing measures, in relation to the other sensor(s), with either an acceptable difference or bias (i.e. a difference or bias below the predetermined threshold) or an excessive difference or bias (i.e. a difference or bias above the predetermined threshold). If at least one bias among the biases of all sensors is excessive, all the sensors are calibrated with the first or the second device, which is rotated by a person, for instance according to a magnetometer calibration procedure or pattern as those known in the art. Accordingly, all the sensors are calibrated at once with a same motion (i.e. rotation) thereby simplifying the calibration procedure; moreover, if all the sensors are of a same model, despite the tolerances of the magnetometers, the bias of the measures corresponding to the magnetometers may be made similar as they are subjected to the same calibration motion.

In some embodiments, the method further comprises, prior to the step of transmitting the first measure corresponding to the respective magnetometer: transmitting, from the computing apparatus to each sensor of the plurality of sensors, a corresponding calibration of the magnetometer if there is any stored in the computing apparatus; and loading, each sensor of the plurality of sensors, the corresponding calibration of the magnetometer.

When former calibrations of the sensors were stored in the computing apparatus, before determining whether the measures of the sensors have an acceptable/excessive difference with respect to the measures of other sensors, the computing apparatus may send the calibrations to the sensors. The sensors load the respective calibrations of the magnetometers and then transmit the measure to the computing apparatus; the measure is influenced by the calibration loaded.

In some other embodiments, the method further comprises, prior to the step of transmitting the first measure corresponding to the respective magnetometer, loading, each sensor of the plurality of sensors, a calibration of the magnetometer that is stored in a memory of the respective sensor.

The sensors may be provided with a memory such as non-volatile memory in which they at least store the calibration of the magnetometer.

In some embodiments, the step of transmitting, from each sensor of the plurality of sensors to the computing apparatus, the first measure corresponding to the respective magnetometer comprises transmitting, from each sensor of the plurality of sensors to the computing apparatus, the first measure corresponding to the respective magnetometer and a calibration of the magnetometer.

The sensors transmit the calibration of the magnetometers thereof so that the computing apparatus may store the different calibrations in a memory of the computing apparatus, e.g. non-volatile memory. The computing apparatus may transmit the stored calibrations to the sensors, which in turn load them for adjusting the measures of the sensors.

In some embodiments, the step of calibrating the plurality of sensors by rotating the first device or the second device with the plurality of sensors introduced therein comprises: transmitting, from the computing apparatus to each sensor of the plurality of sensors, a start of calibration instruction; and rotating the first device or the second device with the plurality of sensors introduced therein according to a predetermined calibration procedure.

The computing apparatus, upon determining that at least one difference or bias exceeds the predetermined threshold, transmits the instruction to the sensors so that they all trigger a calibration procedure. While the sensors are in a calibration mode (owing to the instruction), the first device or the second device is rotated according to the predetermined calibration procedure or pattern (a magnetometer calibration procedure or pattern as those known in the art and which is established in the sensors for calibration thereof), which aims at reducing the bias of the measures provided by each sensor relative to the measures of the other sensors.

In some embodiments, the step of calibrating the plurality of sensors by rotating the first device or the second device with the plurality of sensors introduced therein is carried out until the determined differences between second measures corresponding to the magnetometer of each sensor are lower than the predetermined threshold.

The calibration step can be extended for as long as necessary until the differences between the further measures provided by the sensors have a difference lower than the predetermined threshold. In those embodiments in which the calibration is carried out with the second device, the determination of whether the differences between the second measures corresponding to the magnetometer of each sensor are lower than the predetermined threshold takes place while the sensors are in the second device.

In some embodiments, the step of calibrating the plurality of sensors by rotating the first or the second device with the plurality of sensors introduced therein further comprises: transmitting, from each sensor of the plurality of sensors to the computing apparatus, the second measure corresponding to the respective magnetometer; and determining, the computing apparatus, whether differences between the second measure of each sensor and the second measure of the other sensors of the plurality of sensors are lower than the predetermined threshold.

The computing apparatus, upon determining that at least one difference or bias exceeds the predetermined threshold, transmits the instruction to the sensors and, therefore, they all trigger a calibration procedure. While the sensors are in a calibration mode, the first device or the second device is rotated according to the predetermined calibration procedure or pattern (a magnetometer calibration procedure or pattern as those known in the art and which is established in the sensors for calibration thereof) with the aim of reducing the differences between the measures corresponding to the magnetometers of the sensors. In those embodiments in which the calibration is carried out with the second device, the transmission of the second measure and the determination of whether the differences between the second measures corresponding to the magnetometer of each sensor are lower than the predetermined threshold both take place while the sensors are in the second device.

In some embodiments, the step of calibrating the plurality of sensors by rotating the first or the second device with the plurality of sensors introduced therein further comprises repeating the calibrating step if at least one of the differences between the second measures of the plurality of sensors is equal to or greater than the predetermined threshold.

The calibration may be repeated a plurality of times if calibration procedure(s) carried out have not adjusted the measures provided by the sensors sufficiently for the differences thereof to be lower than the predetermined threshold.

In some embodiments, each step of determining whether the differences between a measure (e.g. the first measure, the second measure, etc.) corresponding to the respective magnetometer of each sensor and a measure (e.g. the first measure, the second measure, etc.) corresponding to the respective magnetometer of the other sensors of the plurality of sensors are lower than the predetermined threshold comprises: for each sensor of the plurality of sensors, projecting an orientation corresponding to the measure of the sensor (either the measure itself or the measure processed so as to provide an orientation corresponding to the measure) onto a horizontal plane thereby providing a corresponding vector; computing an angle between each pair of corresponding vectors; and determining that the differences between the measures of the plurality of sensors are lower than the predetermined threshold if each computed angle is lower than the predetermined threshold.

The computing apparatus digitally projects the orientation of the measure of each sensor onto the horizontal plane. For each vector obtained in this manner, angles are computed with respect to the other vectors obtained, that is to say, an angle is computed for each possible pair of vectors. The computing apparatus compares all the angles obtained with the predetermined threshold in order to establish, depending upon on the results of the comparison, whether a calibration procedure should be conducted.

In some embodiments, each step of determining whether the differences between a measure (e.g. the first measure, the second measure, etc.) corresponding to the respective magnetometer of each sensor and a measure (e.g. the first measure, the second measure, etc.) corresponding to the respective magnetometer of the other sensors of the plurality of sensors are lower than the predetermined threshold further comprises, prior to computing the angle between each pair of corresponding vectors: comparing each corresponding vector with other corresponding vectors so as to determine if one or more corresponding vectors have an angle difference greater than 90°; and rotating 180° each corresponding vector having an angle difference greater than 90° with respect to other corresponding vectors.

The at least one cavity of the first device, and also the at least one cavity of the second device in those embodiments in which the second device is provided, is/are adapted to receive the sensors when they are introduced in a particular orientation, but some sensors feature a shape that is regular or symmetrical and, thus, they may be introduced in the at least one cavity in a number of orientations. For instance, the sensors could be introduced rotated 180° with respect to an axis of the sensors, for example a lengthwise axis or a width axis, in which case the magnetic field sensed would be flipped.

When the orientation is projected onto the horizontal plane, the measurement of a sensor introduced into the first device and/or the second device upside down may result in the provision of a vector that is the same as if the sensor had been introduced upright. If the sensor, however, is introduced rotated 180° with respect to some axes thereof, the vector provided upon projecting the orientation onto the horizontal plane may be flipped 180° with respect to other sensors.

By computing the angle difference between the different vectors, it may be established that one or more sensors were introduced flipped into the first device and/or the second device, and the vectors thereof may be rotated 180° so as to correctly determine the bias between the different measures by means of the vectors. It may occur that most sensors are introduced flipped into the first device and/or the second device and only few sensors are introduced in an upright orientation; the computing apparatus does not determine which sensors were introduced correctly or flipped, so it may rotate 180° the vectors of the sensors introduced correctly since there are more sensors that were introduced flipped.

In some embodiments, each step of determining whether the differences between a measure (e.g. the first measure, the second measure, etc.) corresponding to the respective magnetometer of each sensor and a measure (e.g. the first measure, the second measure, etc.) corresponding to the respective magnetometer of the other sensors of the plurality of sensors are lower than the predetermined threshold comprises: for each sensor of the plurality of sensors, projecting an orientation corresponding to the measure of the sensor (either the measure itself or the measure processed so as to provide an orientation corresponding to the measure) onto a horizontal plane thereby providing a corresponding vector; computing an angle between each pair of corresponding vectors; comparing each corresponding vector with other corresponding vectors so as to determine if one or more corresponding vectors have an angle difference greater than 90°; and determining that the differences between the measures of the plurality of sensors are lower than the predetermined threshold if: each computed angle having an angle difference lower than or equal to 90° is lower than the predetermined threshold; and for each computed angle having an angle difference greater than 90°, a result of 180° minus the computed angle is lower than the predetermined threshold.

By conducting such steps, the comparison of the differences with the predetermined threshold is done such that the possibility that one or more sensors may have been introduced in the first device and/or the second device flipped with respect to other sensors is considered. Accordingly, if one sensor is flipped with respect to the other(s) and the comparison of the corresponding vectors results in an angle difference exceeding 90°, instead of rotating the corresponding vector, what is compared with the predetermined threshold is the result of 180° minus the computed angle so that the flipped condition does not influence the determination.

In some embodiments, the method further comprises storing the calibration of the magnetometer of each sensor in the computing apparatus.

In some embodiments, the method further comprises providing, the computing apparatus, an indication that the plurality of sensors is not calibrated if the step of calibrating the plurality of sensors by rotating the first device or the second device with the plurality of sensors introduced therein is repeated a predetermined number of times.

After each calibration procedure, the computing apparatus determines, based on the most recent measures provided by the sensors, whether the biases between the measures of each pair of sensors are acceptable or excessive. If at least one bias is excessive, the calibration procedure may be repeated. If the calibration has been triggered many times yet there is at least one excessive bias every time, further calibrations may not be carried out and an indication that the sensors could not be calibrated is provided.

In some embodiments, measures transmitted from each sensor of the plurality of sensors to the computing apparatus are three-dimensional magnetic field vectors.

In some embodiments, each step of determining whether the differences between a measure (e.g. the first measure, the second measure, etc.) corresponding to the respective magnetometer of each sensor and a measure (e.g. the first measure, the second measure, etc.) corresponding to the respective magnetometer of the other sensors of the plurality of sensors are lower than the predetermined threshold comprises: computing an angle between each pair of corresponding three-dimensional magnetic field vectors; and determining that the differences between the measures of the plurality of sensors are lower than the predetermined threshold if each computed angle is lower than the predetermined threshold.

In some embodiments, each step of determining whether the differences between a measure (e.g. the first measure, the second measure, etc.) corresponding to the respective magnetometer of each sensor and a measure (e.g. the first measure, the second measure, etc.) corresponding to the respective magnetometer of the other sensors of the plurality of sensors are lower than the predetermined threshold comprises: computing a Euclidean distance between each pair of corresponding three-dimensional magnetic field vectors; and determining that the differences between the measures of the plurality of sensors are lower than the predetermined threshold if each Euclidean distance is lower than the predetermined threshold.

The verification of the measures provided by the sensors is based on the angle difference between the magnetic field vectors or the Euclidean distance between said magnetic field vectors. Accordingly, it is possible to establish the difference between the measures with respect to the actual Earth's magnetic field.

In some embodiments, the measures transmitted from each sensor of the plurality of sensors to the computing apparatus are provided by the sensors upon combining, with a sensor fusion processing, a magnetic field sensed by the respective magnetometer with at least one or more measures of the respective gyroscope and accelerometer.

Some sensors including a magnetometer, a gyroscope and an accelerometer also include at least one processor that is programmed to run a sensor fusion algorithm. The at least one processor inputs to the sensor fusion algorithm at least a magnetic field sensed by the magnetometer, and one or more measures of the gyroscope and/or the accelerometer. The sensor fusion algorithm at least outputs a measure (e.g. the first measure, the second measure, etc.) corresponding to the magnetometer which is the magnetic field sensed but modified according to the one or more measures of the gyroscope and/or the accelerometer. Accordingly, the sensor fusion algorithm is intended to reduce the error in the magnetic field sensed with that additional data.

In some embodiments, the method further comprises providing, the computing apparatus, an indication that the plurality of sensors is calibrated if all differences between the measures (e.g. the first measures, the second measures, etc.) of the plurality of sensors are lower than the predetermined threshold.

In some embodiments, the method further comprises providing, the computing apparatus, an indication of calibration instructions and calibration status of the plurality of sensors.

The user may know how to proceed with the calibration and what is the status thereof based on the indications provided.

In some embodiments, each sensor of the plurality of sensors is a MARG sensor.

Magnetic, angular rate and gravity (MARG) sensors are sensors particularly useful for some applications, such as motion tracking applications, and whose magnetometer may have to be calibrated frequently.

A second aspect of the invention refers to a system for calibrating a plurality of sensors each comprising a magnetometer, a gyroscope and an accelerometer, the system comprising: a device comprising at least one cavity adapted for introduction of one or more sensors; and a computing apparatus comprising at least one processor, at least one memory and means for transmitting and receiving data, the computing apparatus being programmed to: receive, from each sensor of the plurality of sensors, at least one measure corresponding to the respective magnetometer; determine whether the at least one measure of each sensor differs from the at least one measure of the other sensors of the plurality of sensors by less than a predetermined threshold; and transmit start of calibration instructions to the plurality of sensors when a difference between the at least one measure from one of the sensors and the at least one measure of at least one other of the sensors is equal to or greater than the predetermined threshold.

The at least one cavity of the device may be a single cavity in which two or more sensors may be introduced side-by-side, or be a plurality of cavities, in each of which one sensors may be introduced. The sensors introduced into the device transmit the measure(s), corresponding to the magnetometers, to the computing apparatus.

The computing apparatus determines, based on the measures received, if the sensors are measuring, in relation to the other sensor(s), with either an acceptable difference or bias or an excessive difference or bias. The computing apparatus commands the sensors to start a calibration procedure by transmitting a start of calibration instruction if at least one difference exceeds the predetermined threshold, which is set in the computing apparatus. By rotating the device, all the sensors may be calibrated at once by means of a same calibration motion imparted by a person.

In some embodiments, the device is a first device of the system, and the system further comprises a second device comprising at least one cavity adapted for introduction of one or more sensors.

The second device is used for calibrating the sensors in those embodiments in which the first device has large dimensions or heavy weight and, thus, it is difficult to rotate it by a person while having the sensors introduced therein. To this end, the sensors are introduced into the second device for calibrating the same one or more times.

In some embodiments, the computing apparatus is programmed to determine whether the at least one measure of each sensor differs from the at least one measure of the other sensors of the plurality of sensors by less than the predetermined threshold by: projecting orientations corresponding to the at least one measure of each sensor of the plurality of sensors onto a horizontal plane thereby providing corresponding vectors; computing an angle between each pair of corresponding vectors; and determining that the differences between the at least one measure of the plurality of sensors are lower than the predetermined threshold if each computed angle is lower than the predetermined threshold.

In some embodiments, the computing apparatus is programmed to determine whether the at least one measure of each sensor differs from the at least one measure of the other sensors of the plurality of sensors by less than the predetermined threshold further by, prior to computing the angle between each pair of corresponding vectors: comparing each corresponding vector with other corresponding vectors so as to determine if one or more corresponding vectors have an angle difference greater than 90°; and rotating 180° each corresponding vector having an angle difference greater than 90° with respect to other corresponding vectors.

In some embodiments, the computing apparatus is programmed to determine whether the at least one measure of each sensor differs from the at least one measure of the other sensors of the plurality of sensors by less than the predetermined threshold by: projecting orientations corresponding to the at least one measure of each sensor of the plurality of sensors onto a horizontal plane thereby providing corresponding vectors; computing an angle between each pair of corresponding vectors; comparing each corresponding vector with other corresponding vectors so as to determine if one or more corresponding vectors have an angle difference greater than 90°; and determining that the differences between the at least one measure of the plurality of sensors are lower than the predetermined threshold if: each computed angle having an angle difference lower than or equal to 90° is lower than the predetermined threshold; and for each computed angle having an angle difference greater than 90°, a result of 180° minus the computed angle is lower than the predetermined threshold.

In some embodiments, the at least one measure received at the computing apparatus from each sensor of the plurality of sensors is a processed measure resulting from a sensor fusion processing that combines a magnetic field sensed by the respective magnetometer with at least one or more measures of the respective gyroscope and accelerometer.

In some embodiments, the at least one measure received at the computing apparatus from each sensor of the plurality of sensors is a three-dimensional magnetic field vector.

In some embodiments, the computing apparatus is programmed to determine whether the at least one measure of each sensor differs from the at least one measure of the other sensors of the plurality of sensors by less than the predetermined threshold by: computing an angle between each pair of corresponding three-dimensional magnetic field vectors; and determining that the differences between the measures of the plurality of sensors are lower than the predetermined threshold if each computed angle is lower than the predetermined threshold.

In some embodiments, the computing apparatus is programmed to determine whether the at least one measure of each sensor differs from the at least one measure of the other sensors of the plurality of sensors by less than the predetermined threshold by: computing a Euclidean distance between each pair of corresponding three-dimensional magnetic field vectors; and determining that the differences between the measures of the plurality of sensors are lower than the predetermined threshold if each Euclidean distance is lower than the predetermined threshold.

In some embodiments, the computing apparatus is further programmed to repeat transmission of start of calibration instruction to the plurality of sensors if at least one measure of each sensor differs from the at least one measure of the other sensors of the plurality of sensors by the predetermined threshold or more than the predetermined threshold. In some of these embodiments, the computing apparatus is further programmed to provide an indication that the plurality of sensors is not calibrated if the calibration is repeated a predetermined number of times.

In some embodiments, the computing apparatus is further programmed to: store calibrations of the magnetometer of one or more sensors of the plurality of sensors; and transmit stored calibrations to one or more sensors of the plurality of sensors. In some of these embodiments, the computing apparatus is further programmed to receive calibrations of the magnetometer of one or more sensors of the plurality of sensors.

In some embodiments, the computing apparatus is further programmed to provide an indication of calibration instructions and calibration status of the plurality of sensors.

In some embodiments, the system further comprises a plurality of sensors. In some of these embodiments, each sensor further comprises means for transmitting and receiving data. In some of these embodiments, each sensor further comprises at least one processor programmed to apply a sensor fusion processing to a magnetic field sensed by the magnetometer and at least one or more measures of the gyroscope and the accelerometer, thereby providing the at least one measure.

In some embodiments, each sensor of the plurality of sensors is a MARG sensor.

Similar advantages as those described with respect to the first aspect of the invention are also applicable to this aspect of the invention.

### BRIEF DESCRIPTION OF THE DRAWINGS

To complete the description and in order to provide for a better understanding of the invention, a set of drawings is provided. Said drawings form an integral part of the description and illustrate embodiments of the invention, which should not be interpreted as restricting the scope of the invention, but just as examples of how the invention can be carried out. The drawings comprise the following figures:
Figures 1A-1B show a device for calibration of sensors.
Figure 2 diagrammatically shows a system in accordance with an embodiment.
Figure 3 diagrammatically shows a method in accordance with an embodiment.
Figures 4-7 diagrammatically show steps of methods in accordance with embodiments.
Figures 8A-8B and 9 diagrammatically show processing of measures of methods and systems in accordance with embodiments.
Figure 10 shows the device of Figures 1A-1B being manipulated by a user.
Figure 11 diagrammatically shows a method in accordance with an embodiment.

### DESCRIPTION OF WAYS OF CARRYING OUT THE INVENTION

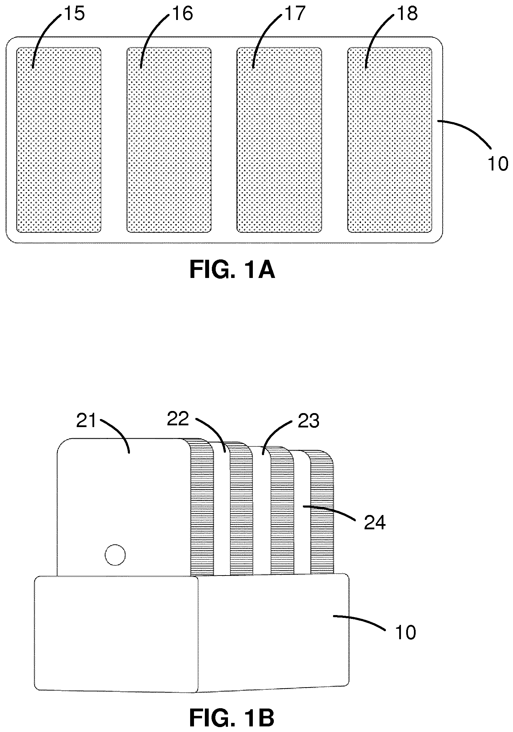

Figures 1A-1B show a device 10 for calibration of sensors. In Figure 1A the device 10 is shown from a top view, and in Figure 1B the device 10 is shown in perspective with a plurality of sensors 21-24 introduced therein.

The device 10 comprises a plurality of cavities 15-18 adapted to receive a sensor 21-24.

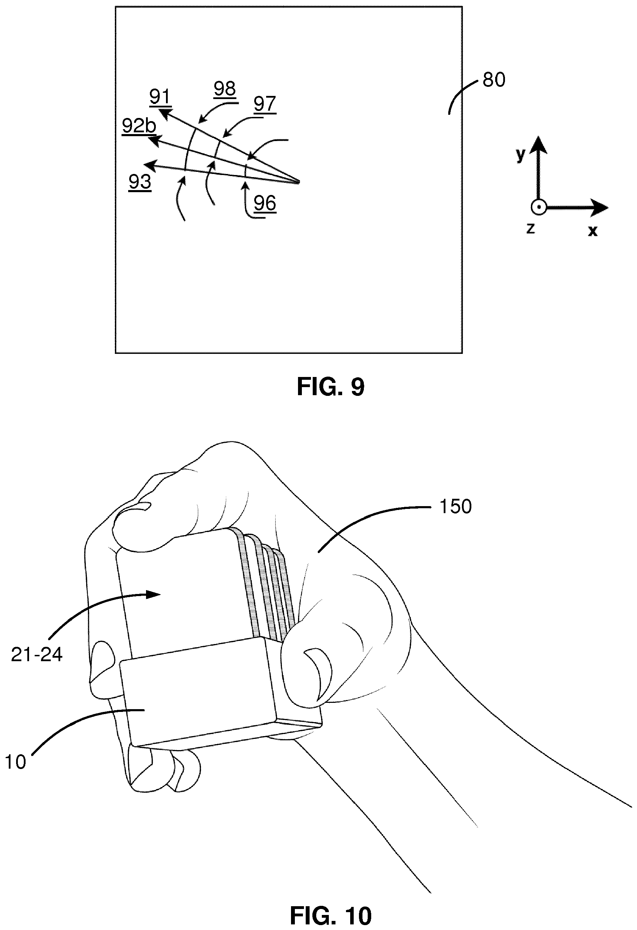

The cavities 15-18 are dimensioned such that the sensors 21-24 may be introduced with a particular orientation thereof. The sensors 21-24 may fit tightly or with some play, in which case the rotation of the device 10 for calibrating the sensors 21-24 may require covering the sensors with the hand so that they do not fall off from the device 10, as shown in Figure 10.

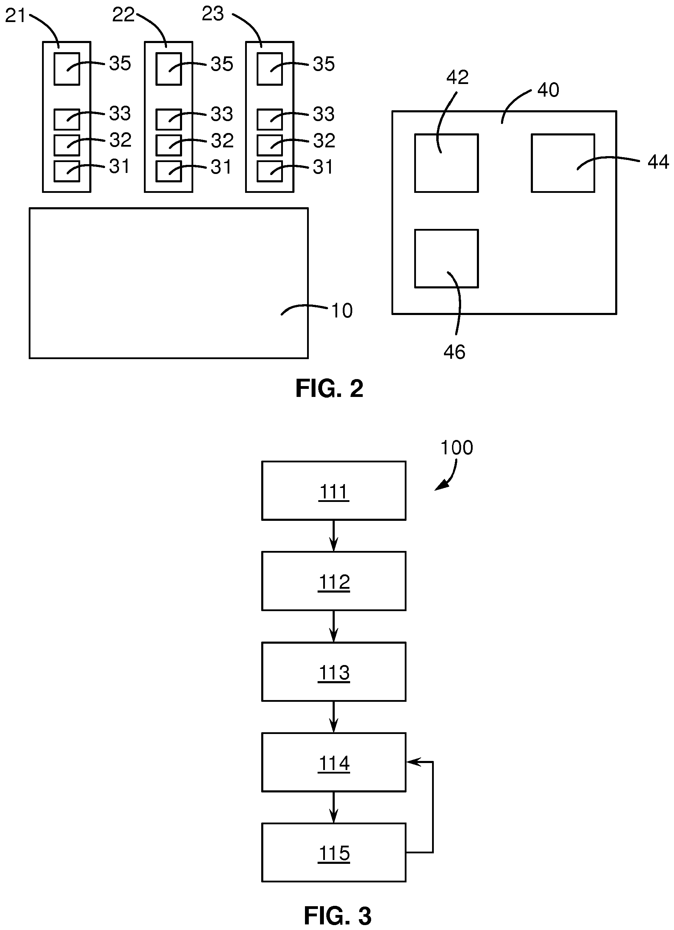

Figure 2 diagrammatically shows a system 5 in accordance with an embodiment.

The system 5 comprises the device 10, a computing apparatus 40, and a plurality of sensors 21-23. In some embodiments, the sensors 21-23 are not part of the system.

The computing apparatus 40 comprises at least one processor 42, at least one memory 44, and means 46 for transmitting and receiving data. The computing apparatus 40 may be a computer, a wireless electronic device such as a mobile phone or a tablet, a single-board computer, a microcontroller, etc.

Each sensor 21-23 at least comprises a magnetometer 31, a gyroscope 32, an accelerometer 33, and means 35 for transmitting and receiving data. In some examples, the sensors 21-23 also comprise at least one processor (not illustrated) that may be configured to run a sensor fusion algorithm with at least the values sensed by the magnetometer and the values sensed by the gyroscope and/or the accelerometer. In the example illustrated in Figure 2, the sensors 21-23 are MARG sensors.

The measures resulting from the sensing of the magnetometers 31 are sent to the computing apparatus 40 using the means 35 for transmitting and receiving data (preferably the transmission is carried out wirelessly, for example via Bluetooth, WLAN, or cellular communications, but could also be carried out via a wired connection). The computing apparatus 40 receives the measures through its means 46 for transmitting and receiving data, and the at least one processor 42 determines the differences between each pair of measures and commands the calibration thereof if at least one difference exceeds a predetermined threshold.

In this embodiment there are three sensors 21-23, however in other embodiments there may be two, four, five or even more than five sensors.

In some embodiments, the computing apparatus 40 further comprises a display, or notification LEDs, or a combination thereof, that may be used for indicating to a user how to calibrate the sensors 21-23 and what is the calibration status thereof. In some embodiments, the computing apparatus 40 uses the means 46 for transmitting and receiving data to send information regarding the calibration to another device, that may be remote from the computing apparatus 40, which in turn displays said information.

Figure 3 diagrammatically shows a method 100 in accordance with an embodiment.

The method 100 comprises a step of providing 111 a device (for example the device 10 of Figures 1A-1B and 2) with at least one cavity adapted for introduction of one or more sensors (for example the sensors 21-24 of Figure 1B or the sensors 21-23 of Figure 2).

The method 100 further comprises a step of introducing 112 the sensors into the device, particularly into one of the at least one cavity.

The method 100 further comprises a step of transmitting 113, from each sensor to a computing apparatus (for example the computing apparatus 40 of Figure 2), one or more first measures corresponding to the magnetometer of the sensors that are introduced into the device. In this respect, the computing apparatus receives said one or more first measures.

The method 100 further comprises a step of determining 114 whether the biases between a measure corresponding to the magnetometer of each sensor and a measure corresponding to the magnetometer of the other sensors of the plurality of sensors are lower than a predetermined threshold. To this end, at least one processor (for example the at least one processor 42 of Figure 2) of the computing apparatus is configured to carry out this determining 114 step together with at least one memory thereof (for example the at least one memory 44 of Figure 2).

The method 100 further comprises a step of calibrating 115 the sensors introduced in the device if in the determining 114 step it was determined that at least one bias of the measure of a sensor, relative to the measure of another sensor, is equal to or greater than the predetermined threshold. For calibrating 115 the sensors, the device is rotated according to a magnetometer calibration procedure or pattern (i.e. the way in which the sensors have to be rotated) known in the art until the biases of all the sensors are lower than the predetermined threshold according to further measure(s) (corresponding to the magnetometers) provided by them. The calibration procedure or pattern itself is not within the scope of the present disclosure. Therefore, the method 100 may repeat the determining 114 and calibrating 115 steps in order to achieve such biases.

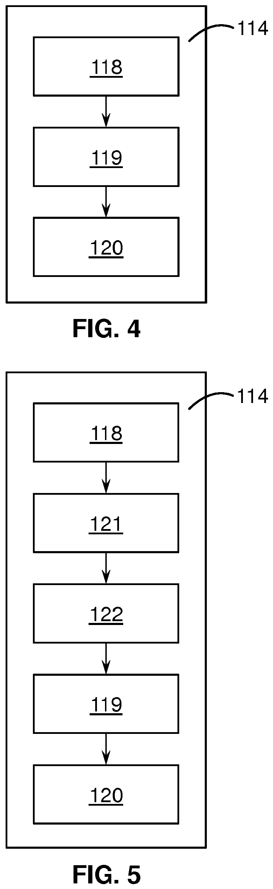

Figure 4 diagrammatically shows a determining 114 step of methods in accordance with embodiments.

The determining 114 step comprises a step of projecting 118 one or more orientation(s) corresponding to measures, which correspond to the magnetometer of each sensor, onto a horizontal plane so as to provide a vector of each orientation.

The determining 114 step further comprises a step of computing 119 an angle between each pair of vectors provided in the projecting 118 step.

The determining 114 step further comprises a step of determining 120 whether the sensors introduced into the device provide measures with biases (relative to the measures of the other sensors) that are lower than the predetermined threshold. In order to determine 120 that the biases are lower than the predetermined threshold, each angle of the computing 119 step must be lower than the predetermined threshold.

In some embodiments, prior to the step of determining 120 whether the sensors provide measures with biases lower than the predetermined threshold, a step of comparing each corresponding vector with other corresponding vectors is conducted in order to determine if one or more corresponding vectors have an angle difference greater than 90°. In these embodiments, in the step of determining 120 whether the sensors provide measures with biases lower than the predetermined threshold, each angle of the computing 119 step which does not have an angle difference greater than 90° (according to the comparing step) must be lower than the predetermined threshold, whereas each angle of the computing 119 step which has an angle difference greater than 90° (according to the comparing step), a result of 180° minus the angle computed 119 must be lower than the predetermined threshold.

The at least one processor of the computing apparatus is configured, together with the at least one memory, to carry out each of the projecting 118, computing 119 and determining 120 steps.

Figure 5 diagrammatically shows a determining 114 step of methods in accordance with embodiments.

The determining 114 step comprises the step of projecting 118 the one or more orientation(s) onto the horizontal plane.

The determining 114 step further comprises a step of comparing 121 each vector of the projecting 118 step with other vectors of the projecting step 118 so as to determine if one or more vectors have an angle difference greater than 90°.

The determining 114 step further comprises a step of rotating 122 180° each vector whose angle difference, according to the comparing 121 step, is greater than 90° with respect to other vectors.

The determining 114 step further comprises the step of computing 119 the angle between each pair of vectors (once any rotation 122 necessary has been carried out), and the step of determining 120 whether the sensors introduced in the device provide measures with biases (relative to the measures of the other sensors) that are lower than the predetermined threshold.

The at least one processor of the computing apparatus is further configured, together with the at least one memory, to carry out each of the comparing 121 and rotating 122 steps.

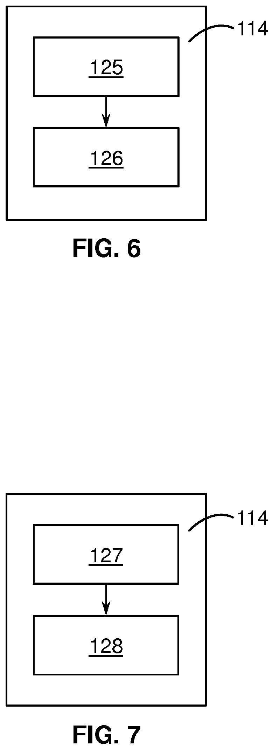

Figure 6 diagrammatically shows a determining 114 step of methods in accordance with embodiments.

The determining 114 step comprises a step of computing 125 an angle between each pair of measures provided by the sensors, the measuring corresponding to three-dimensional magnetic field vectors.

The determining 114 step further comprises a step of determining 126 that the differences between the measures of the sensors are lower than the predetermined threshold if each angle of the computing 125 step is lower than the predetermined threshold.

Figure 7 diagrammatically shows a determining 114 step of methods in accordance with embodiments.

The determining 114 step comprises a step of computing 127 a Euclidean distance between each pair of measures provided by the sensors, the measuring corresponding to three-dimensional magnetic field vectors.

The determining 114 step further comprises a step of determining 128 that the differences between the measures of the sensors are lower than the predetermined threshold if each Euclidean distance of the computing 127 step is lower than the predetermined threshold.

The at least one processor of the computing apparatus is further configured, together with the at least one memory, to carry out each of the computing 125, 127 and determining 126, 128 steps.

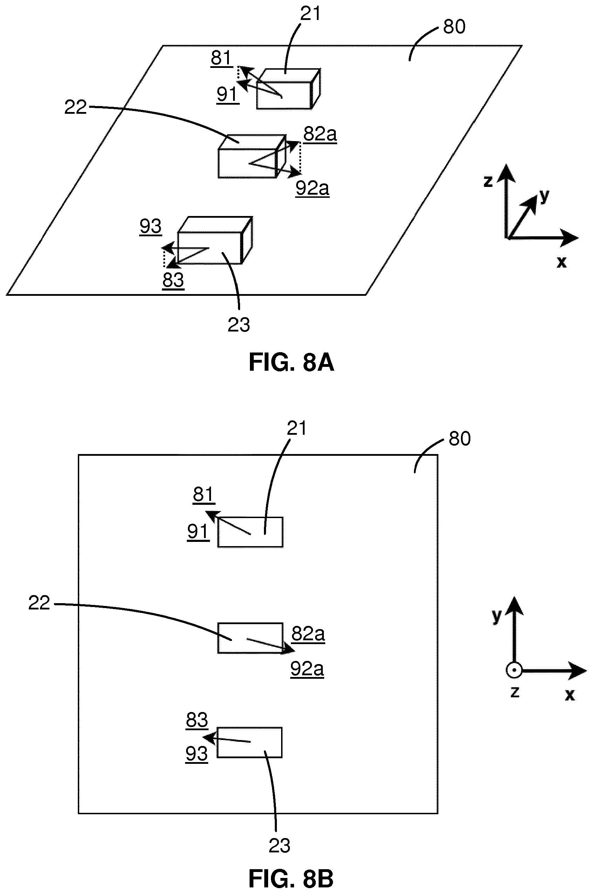

Figures 8A-8B diagrammatically show processing of orientations of methods and systems in accordance with embodiments. Figure 8A shows, in a 3D view, the processing, whereas Figure 8B shows the same processing from a top view.

Each sensor 21-23 provides a measure of a magnetic field, owing to the magnetometer thereof, in the form of orientations 81, 82a, 83, respectively, in an Earth's reference frame. The orientations 81, 82a, 83 may be provided, for example, in the form of 3D vectors as illustrated in Figure 8A.

The computing apparatus projects the orientations 81, 82a, 83 onto a horizontal plane 80 (i.e. a plane that, in a Cartesian coordinate system, extends in X and Y dimensions and is defined by a constant height, that is a constant Z dimension), thereby providing respective vectors 91, 92a, 93. In Figure 8B, the vectors 91, 92a, 93 match the orientations 81, 82a, 83 because the projection onto the horizontal plane 80 relates to the Z dimension. In the example of Figures 8A-8B, the orientations 81 and 82a are directed towards the positive Z dimension whereas the orientation 83 is directed towards the negative Z dimension.

Figure 9 diagrammatically shows processing of the vectors 91, 92a, 93 of Figures 8A-8B, from a top view of the horizontal plane 80.

In this example, the vectors 91, 92a, 93 are compared one to each other so as to determine whether any of the sensors 21-23 was introduced into the device rotated 180° with respect to the other sensors. By comparing the angles between each pair of vectors 91, 92a, 93 it is determined that the sensor 22 was introduced flipped into the device with respect to the other sensors as the angle difference of the vector 92a thereof relative to the other vectors 91 and 93 is greater than 90°. Accordingly, the vector 92a may be rotated 180° so as to provide a further vector 92b, even though in some embodiments the vector is not rotated but the predetermined threshold is compared to the result of 180° minus the difference in angle between said vector and another vector.

The vectors 91, 92b, 93 are then compared to determine whether the biases between them, that is the angle differences between these vectors, are lower than the predetermined threshold, e.g. angles of 3°, 5°, 8°, etc. First, second and third angles 96-98 are computed (resulting from each possible pair of vectors 91, 92b, 93), and then compared with the predetermined threshold. If all the angles 96-98 are less than the predetermined threshold, it is determined that the sensors 21-23 have an acceptable bias, otherwise at least one has an excessive bias, therefore the sensors must be calibrated.

Figure 10 shows the device 10 of Figures 1A-1B being manipulated by a user.

The plurality of cavities 15-18 of the device 10 are dimensioned such that the sensors 21-24 are introduced therein with some play. Therefore, the user in order to perform the rotation of the device 10 to calibrate the sensors 21-24 covers the sensors with his/her hand 150 so that the sensors do not fall off.

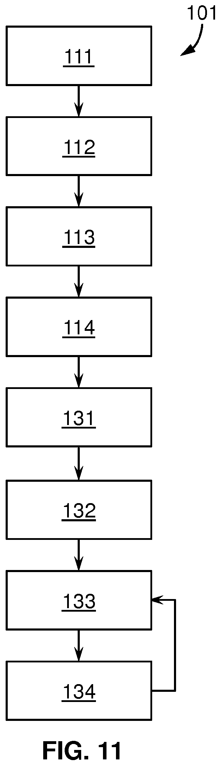

Figure 11 diagrammatically shows a method 101 in accordance with an embodiment.

The method 101 is similar to the method 100 of Figure 3 but involving the use of two devices. A first part of the method 101 is conducted with a first device and a second part of the method 101 is conducted with a second device. The first device may be used for verifying that a magnetic field measure of the sensors does not differ from the magnetic field measure of the other sensors by more than a certain value, and also for storing the sensors while they are not in use. The second device may be used for calibrating the sensors and for conducting a similar verification while the sensors are being subjected to the calibration procedure.

The first device with at least one cavity adapted for introduction of one or more sensors is provided 111. The sensors are introduced 112 into the first device. Each sensor transmits 113, to the computing apparatus, one or more first measures corresponding to the magnetometer of the sensors that are introduced into the first device. The computing apparatus determines 114 whether the biases between a measure corresponding to the magnetometer of each sensor and a measure corresponding to the magnetometer of the other sensors of the plurality of sensors are lower than a predetermined threshold.

The method 101 further comprises a step of providing 131 the second device with at least one cavity adapted for introduction of one or more sensors (for example the device 10 of Figures 1A-1B and 2).

The method 101 further comprises a step of introducing 132 the sensors into the second device.

The method 101 further comprises calibrating 133 the sensors by rotating the second device with the sensors introduced therein according to a magnetometer calibration procedure or pattern if it was determined 114 that at least one bias of the measure of a sensor, relative to the measure of another sensor, is equal to or greater than the predetermined threshold.

The method 101 further comprises determining 134, the computing apparatus, whether the biases between a measure corresponding to the magnetometer of each sensor and a measure corresponding to the magnetometer of the other sensors of the plurality of sensors are lower than the predetermined threshold; these measures are transmitted while the calibration 133 procedure is under way or after the same has ended, thus they are transmitted while the sensors are introduced in the second device. If at least one bias is greater than the predetermined threshold, both the calibration 133 and the determination 134 steps may be further carried out one or more times.

The second determining 134 step is based on a same processing as the first determining 114 step, thus the processing described with reference to any of Figures 4-9 applies to this second determining 134 step as well.

In this text, the term "comprises" and its derivations (such as "comprising", etc.) should not be understood in an excluding sense, that is, these terms should not be interpreted as excluding the possibility that what is described and defined may include further elements, steps, etc.

On the other hand, the invention is obviously not limited to the specific embodiment(s) described herein, but also encompasses any variations that may be considered by any person skilled in the art (for example, as regards the choice of materials, dimensions, components, configuration, etc.), within the scope of the invention as defined in the claims.

## Claims

1. A method (100) for calibrating a plurality of sensors (21-24) each comprising a magnetometer (31), a gyroscope (32) and an accelerometer (33), the method comprising:
providing (111) a first device (10) comprising at least one cavity (15-18) adapted for introduction of one or more sensors (21-24), the at least one cavity being dimensioned such that the one or more sensors fit therein when the sensors are introduced with a particular orientation;
introducing (112) each sensor of the plurality of sensors (21-24) into the first device (10);
transmitting (113), from each sensor of the plurality of sensors (21-24) to a computing apparatus (40), a first measure corresponding to the respective magnetometer (31);
**characterised by**:
determining (114), the computing apparatus (40), whether differences between the first measure of each sensor and the first measure of the other sensors of the plurality of sensors (21-24) are lower than a predetermined threshold; and
calibrating (115) the plurality of sensors (21-24), if at least one of the differences between the first measures is equal to or greater than the predetermined threshold, by rotating the first device (10) or a second device (10) with the plurality of sensors (21-24) introduced therein, the second device (10) comprising at least one cavity (15-18) adapted for introduction of one or more sensors (21-24).

2. The method (100) of claim 1, wherein the step of calibrating (115) the plurality of sensors (21-24) by rotating the first device (10) or the second device (10) with the plurality of sensors introduced (21-24) therein comprises:
transmitting, from the computing apparatus (40) to each sensor of the plurality of sensors (21-24), a start of calibration instruction; and
rotating (115) the first device (10) or the second device (10) with the plurality of sensors (21-24) introduced therein according to a predetermined calibration procedure.

3. The method (100) of any of the preceding claims, wherein the step of calibrating (115) the plurality of sensors (21-24), if at least one of the differences between the first measures is equal to or greater than the predetermined threshold, by rotating the first device (10) or the second device (10) with the plurality of sensors (21-24) introduced therein is carried out until the determined differences between second measures corresponding to the magnetometer (31) of each sensor are lower than the predetermined threshold; and wherein the method further comprises:
transmitting, from each sensor of the plurality of sensors (21-24) to the computing apparatus (40), the second measure corresponding to the respective magnetometer (31); and
determining (115), the computing apparatus (40), whether differences between the second measure of each sensor and the second measure of the other sensors of the plurality of sensors (21-24) are lower than the predetermined threshold.

4. The method (100) of claim 3, wherein the step of calibrating (115) the plurality of sensors (21-24) by rotating the first device (10) or the second device (10) with the plurality of sensors (21-24) introduced therein further comprises repeating the calibrating (115) step if at least one of the differences between the second measures of the plurality of sensors (21-24) is equal to or greater than the predetermined threshold.

5. The method (100) of any of the preceding claims, wherein each step of determining (114) whether the differences between a measure corresponding to the respective magnetometer (31) of each sensor and a measure corresponding to the respective magnetometer (31) of the other sensors of the plurality of sensors (21-24) are lower than the predetermined threshold comprises:
for each sensor of the plurality of sensors (21-24), projecting (118) an orientation corresponding to the measure of the sensor onto a horizontal plane thereby providing a corresponding vector;
computing (119) an angle between each pair of corresponding vectors; and
determining (120) that the differences between the measures of the plurality of sensors (21-24) are lower than the predetermined threshold if each computed angle is lower than the predetermined threshold.

6. The method (100) of any of claims 1-4, wherein each step of determining (114) whether the differences between a measure corresponding to the respective magnetometer (31) of each sensor and a measure corresponding to the respective magnetometer (31) of the other sensors of the plurality of sensors (21-24) are lower than the predetermined threshold comprises:
for each sensor of the plurality of sensors (21-24), projecting (118) an orientation corresponding to the measure of the sensor onto a horizontal plane thereby providing a corresponding vector;
computing (119) an angle between each pair of corresponding vectors;
comparing (121) each corresponding vector with other corresponding vectors so as to determine if one or more corresponding vectors have an angle difference greater than 90°; and
determining (120) that the differences between the measures of the plurality of sensors (21-24) are lower than the predetermined threshold if:
each computed angle having an angle difference lower than or equal to 90° is lower than the predetermined threshold; and
for each computed angle having an angle difference greater than 90°, a result of 180° minus the computed angle is lower than the predetermined threshold.

7. The method (100) of any of claims 1-4, wherein measures transmitted (113) from each sensor of the plurality of sensors (21-24) to the computing apparatus (40) are three-dimensional magnetic field vectors.

8. The method (100) of claim 7, wherein each step of determining (114) whether the differences between a measure corresponding to the respective magnetometer (31) of each sensor and a measure corresponding to the respective magnetometer (31) of the other sensors of the plurality of sensors (21-24) are lower than the predetermined threshold comprises:
computing (125) an angle between each pair of corresponding three-dimensional magnetic field vectors; and
determining (126) that the differences between the measures of the plurality of sensors (21-24) are lower than the predetermined threshold if each computed angle is lower than the predetermined threshold.

9. The method (100) of claim 7, wherein each step of determining (114)whether the differences between a measure corresponding to the respective magnetometer (31) of each sensor and a measure corresponding to the respective magnetometer (31) of the other sensors of the plurality of sensors (21-24) are lower than the predetermined threshold comprises:
computing (127) a Euclidean distance between each pair of corresponding three-dimensional magnetic field vectors; and
determining (128) that the differences between the measures of the plurality of sensors (21-24) are lower than the predetermined threshold if each Euclidean distance is lower than the predetermined threshold.

10. The method (100) of any of the preceding claims, wherein measures transmitted (113) from each sensor of the plurality of sensors (21-24) to the computing apparatus (40) are provided by the sensors (21-24) upon combining, with a sensor fusion processing, a magnetic field sensed by the respective magnetometer (31) with at least one or more measures of the respective gyroscope (32) and accelerometer (33).

11. A system (5) for calibrating a plurality of sensors (21-24) each comprising a magnetometer (31), a gyroscope (32) and an accelerometer (33), the system comprising:
a device (10) comprising at least one cavity (15-18) adapted for introduction of one or more sensors (21-24); and
a computing apparatus (40) comprising at least one processor (42), at least one memory (44) and means (46) for transmitting and receiving data, the computing apparatus (40) being programmed to:
receive, from each sensor of the plurality of sensors (21-24), at least one
measure corresponding to the respective magnetometer (31); **characterised in that** the computing apparatus (40) is further programmed to:
determine (114) whether the at least one measure of each sensor differs from the at least one measure of the other sensors of the plurality of sensors (21-24) by less than a predetermined threshold; and
transmit start of calibration instructions to the plurality of sensors (21-24) when a difference between the at least one measure from one of the sensors (21-24) and the at least one measure of at least one other of the sensors (21-24) is equal to or greater than the predetermined threshold.

12. The system (5) of claim 11, wherein the computing apparatus (40) is programmed to determine (114) whether the at least one measure of each sensor differs from the at least one measure of the other sensors of the plurality of sensors (21-24) by less than the predetermined threshold by:
projecting (118) orientations corresponding to the at least one measure of each sensor of the plurality of sensors (21-24) onto a horizontal plane thereby providing corresponding vectors;
computing (119) an angle between each pair of corresponding vectors; and
determining (120) that the differences between the at least one measure of the plurality of sensors (21-24) are lower than the predetermined threshold if each computed angle is lower than the predetermined threshold.

13. The system (5) of claim 11, wherein the at least one measure received at the computing apparatus (40) from each sensor of the plurality of sensors (21-24) is a three-dimensional magnetic field vector; and wherein the computing apparatus (40) is programmed to determine (114) whether the at least one measure of each sensor differs from the at least one measure of the other sensors of the plurality of sensors (21-24) by less than the predetermined threshold by:
computing (119) an angle between each pair of corresponding three-dimensional magnetic field vectors; and
determining (120) that the differences between the at least one measure of the plurality of sensors (21-24) are lower than the predetermined threshold if each computed angle is lower than the predetermined threshold.

14. The system (5) of claim 11, wherein the at least one measure received at the computing apparatus (40) from each sensor of the plurality of sensors (21-24) is a three-dimensional magnetic field vector; and wherein the computing apparatus (40) is further programmed to determine (114) whether the at least one measure of each sensor differs from the at least one measure of the other sensors of the plurality of sensors (21-24) by less than the predetermined threshold by:
computing (119) a Euclidean distance between each pair of corresponding three-dimensional magnetic field vectors; and
determining (120) that the differences between the at least one measure of the plurality of sensors (21-24) are lower than the predetermined threshold if each Euclidean distance is lower than the predetermined threshold.

15. The system (5) of any of claims 11-14, further comprising the plurality of sensors (21-24), each sensor further comprising at least one processor programmed to apply a sensor fusion processing to a magnetic field sensed by the magnetometer (31) and at least one or more measures of the gyroscope (32) and the accelerometer (33), thereby providing the at least one measure.

## Patentansprüche

1. Verfahren (100) zum Kalibrieren einer Mehrzahl von Sensoren (21-24), die jeweils ein Magnetometer (31), ein Gyroskop (32) und einen Beschleunigungsmesser (33) aufweisen, wobei das Verfahren das Folgende aufweist:
Bereitstellen (111) einer ersten Vorrichtung (10), die mindestens einen Hohlraum (15-18) aufweist, der für das Einbringen eines oder mehrerer Sensoren (21-24) angepasst ist, wobei der mindestens eine Hohlraum so dimensioniert ist, dass der eine oder die mehreren Sensoren hineinpassen, wenn die Sensoren in einer bestimmten Ausrichtung eingebracht werden;
Einbringen (112) jedes Sensors der Mehrzahl von Sensoren (21-24) in die erste Vorrichtung (10);
Senden (113) einer ersten Messung, die zu dem entsprechenden Magnetometer (31) gehört, von jedem Sensor der Mehrzahl von Sensoren (21-24) an eine Rechenvorrichtung (40); **gekennzeichnet durch**:
Bestimmen (114) durch die Rechenvorrichtung (40), ob Differenzen zwischen der ersten Messung jedes Sensors und der ersten Messung der anderen Sensoren der Mehrzahl von Sensoren (21-24) kleiner als ein vorbestimmter Grenzwert sind; und
Kalibrieren (115) der Mehrzahl von Sensoren (21-24), falls mindestens eine der Differenzen zwischen den ersten Messungen gleich dem oder größer als der vorbestimmte Grenzwert ist, indem die erste Vorrichtung (10) oder eine zweite Vorrichtung (10) mit der Mehrzahl von darin angeordneten Sensoren (21-24) gedreht wird, wobei die zweite Vorrichtung (10) mindestens einen Hohlraum (15, 18) aufweist, der für das Einbringen eines oder mehrerer Sensoren (21, 24) angepasst ist.

2. Verfahren (100) nach Anspruch 1, wobei der Schritt des Kalibrierens (115) der Mehrzahl von Sensoren (21-24) durch Drehen der ersten Vorrichtung (10) oder der zweiten Vorrichtung (10) mit der darin eingebrachten Mehrzahl von Sensoren (21-24) Folgendes aufweist:
Senden eines Befehls zum Beginnen der Kalibrierung von der Rechenvorrichtung (40) an jeden Sensor der Mehrzahl von Sensoren (21-24); und
Drehen (115) der ersten Vorrichtung (10) oder der zweiten Vorrichtung (10) mit der darin eingebrachten Mehrzahl von Sensoren (21-24) gemäß einem vorbestimmten Kalibrierungsvorgang.

3. Verfahren (100) nach mindestens einem der vorhergehenden Ansprüche, wobei, falls mindestens eine der Differenzen zwischen den ersten Messungen gleich dem oder größer als der vorbestimmte Grenzwert ist, der Schritt des Kalibrierens (115) der Mehrzahl von Sensoren (21-24) durch Drehen der ersten Vorrichtung (10) oder der zweiten Vorrichtung (10) mit der darin eingebrachten Mehrzahl von Sensoren (21-24) ausgeführt wird, bis die ermittelten Differenzen zwischen den zweiten Messungen, die zu dem Magnetometer (31) jedes Sensors gehören, kleiner als der vorbestimmte Grenzwert sind; und wobei das Verfahren weiterhin Folgendes aufweist:
Senden der zweiten Messung, die zu dem entsprechenden Magnetometer (31) gehört, von jedem Sensor der Mehrzahl von Sensoren (21-24) an die Rechenvorrichtung (40); und
Bestimmen (115) durch die Rechenvorrichtung (40), ob Differenzen zwischen der zweiten Messung jedes Sensors und der zweiten Messung der anderen Sensoren der Mehrzahl von Sensoren (21-24) kleiner als der vorbestimmte Grenzwert sind.

4. Verfahren (100) nach Anspruch 3, wobei der Schritt des Kalibrierens (115) der Mehrzahl von Sensoren (21-24) durch Drehen der ersten Vorrichtung (10) oder der zweiten Vorrichtung (10) mit der darin eingebrachten Mehrzahl von Sensoren (21-24) weiterhin das Wiederholen des Schritts des Kalibrierens (115) aufweist, falls mindestens eine der Differenzen zwischen den zweiten Messungen der Mehrzahl von Sensoren (21-24) gleich dem oder größer als der vorbestimmte Grenzwert ist.

5. Verfahren (100) nach mindestens einem der vorhergehenden Ansprüche, wobei jeder Schritt des Bestimmens (114), ob die Differenzen zwischen einer zu dem entsprechenden Magnetometer (31) gehörenden Messung jedes Sensors und einer zu dem entsprechenden Magnetometer (31) gehörenden Messung der anderen Sensoren der Mehrzahl von Sensoren (21-24) kleiner als der vorbestimmte Grenzwert ist, das Folgende aufweist:
Projizieren (118) einer Ausrichtung, die zu der Messung des Sensors gehört, auf eine horizontale Ebene für jeden Sensor der Mehrzahl von Sensoren (21-24), wodurch ein entsprechender Vektor bereitgestellt wird;
Berechnen (119) eines Winkels zwischen jedem Paar zugehöriger Vektoren; und
Bestimmen (120), dass die Differenz zwischen den Messungen der Mehrzahl von Sensoren (21-24) kleiner als der vorbestimmte Grenzwert ist, falls jeder berechnete Winkel kleiner als der vorbestimmte Grenzwert ist.

6. Verfahren (100) nach mindestens einem der Ansprüche 1-4, wobei der Schritt des Bestimmens (114), ob die Differenzen zwischen einer zu dem entsprechenden Magnetometer (31) gehörenden Messung jedes Sensors und einer zu dem entsprechenden Magnetometer (31) gehörenden Messung der anderen Sensoren der Mehrzahl von Sensoren (21-24) kleiner als der vorbestimmte Grenzwert ist, das Folgende aufweist:
Projizieren (118) einer Ausrichtung, die zu der Messung des Sensors gehört, auf eine horizontale Ebene für jeden Sensor der Mehrzahl von Sensoren (21-24), wodurch ein entsprechender Vektor bereitgestellt wird;
Berechnen (119) eines Winkels zwischen jedem Paar zugehöriger Vektoren;
Vergleichen (121) jedes zugehörigen Vektors mit anderen zugehörigen Vektoren, um zu bestimmen, ob einer oder mehrere zugehörige Vektoren eine Winkeldifferenz besitzen, die größer als 90° ist; und
Bestimmen (120), dass die Differenz zwischen den Messungen der Mehrzahl von Sensoren (21-24) kleiner als der vorbestimmte Grenzwert ist, falls:
jeder berechnete Winkel mit einer Winkeldifferenz kleiner als oder gleich 90° kleiner als der vorbestimmte Grenzwert ist; und
das Ergebnis von 180° minus dem berechneten Winkel für jeden berechneten Winkel mit einer Winkeldifferenz größer als 90° kleiner als der vorbestimmte Grenzwert ist.

7. Verfahren (100) nach mindestens einem der Ansprüche 1-4, wobei von jedem Sensor der Mehrzahl von Sensoren (21-24) an die Rechenvorrichtung (40) gesendete Messungen (113) dreidimensionale Magnetfeldvektoren sind.

8. Verfahren (100) nach Anspruch 7, wobei jeder Schritt des Bestimmens (114), ob die Differenzen zwischen einer zu dem entsprechenden Magnetometer (31) gehörenden Messung jedes Sensors und einer zu dem entsprechenden Magnetometer (31) gehörenden Messung der anderen Sensoren der Mehrzahl von Sensoren (21-24) kleiner als der vorbestimmte Grenzwert ist, das Folgende aufweist:
Berechnen (125) eines Winkels zwischen jedem Paar zugehöriger dreidimensionaler Magnetfeldvektoren; und
Bestimmen (126), dass die Differenzen zwischen den Messungen der Mehrzahl von Sensoren (21-24) kleiner als der vorbestimmte Grenzwert sind, falls jeder berechnete Winkel kleiner als der vorbestimmte Grenzwert ist.

9. Verfahren (100) nach Anspruch 7, wobei jeder Schritt des Bestimmens (114), ob die Differenzen zwischen einer zu dem entsprechenden Magnetometer (31) gehörenden Messung jedes Sensors und einer zu dem entsprechenden Magnetometer (31) gehörenden Messung der anderen Sensoren der Mehrzahl von Sensoren (21-24) kleiner als der vorbestimmte Grenzwert ist, das Folgende aufweist:
Berechnen (127) eines euklidischen Abstands zwischen jedem Paar zugehöriger dreidimensionaler Magnetfeldvektoren; und
Bestimmen (128), dass die Differenzen zwischen den Messungen der Mehrzahl von Sensoren (21-24) kleiner als der vorbestimmte Grenzwert sind, falls der euklidische Abstand kleiner als der vorbestimmte Grenzwert ist.

10. Verfahren (100) nach mindestens einem der vorhergehenden Ansprüche, wobei von jedem Sensor der Mehrzahl von Sensoren (21-24) an die Rechenvorrichtung (40) gesendete Messungen (113) durch die Sensoren (21-24) bereitgestellt werden aufgrund eines Kombinierens eines mit dem zugehörigen Magnetometer (31) erfassten Magnetfelds mit mindestens einer oder mehreren Messungen des zugehörigen Gyroskops (32) und des Beschleunigungsmessers (33) durch eine Sensorfusionsverarbeitung.

11. System (5) zum Kalibrieren einer Mehrzahl von Sensoren (21-24), die jeweils ein Magnetometer (31), ein Gyroskop (32) und einen Beschleunigungsmesser (33) aufweisen, wobei das System das Folgende aufweist:
eine Vorrichtung (10), die mindestens einen Hohlraum (15-18) aufweist, der für das Einbringen eines oder mehrerer Sensoren (21-24) angepasst ist; und
eine Rechenvorrichtung (40), die mindestens einen Prozessor (42), mindestens einen Speicher (44) und Mittel (46) zum Senden und Empfangen von Daten aufweist, wobei die Rechenvorrichtung (40) für das Folgende programmiert ist:
Empfangen mindestens einer Messung, die zu dem entsprechenden Magnetometer (31) gehört, von jedem Sensor der Mehrzahl von Sensoren (21-24); **dadurch gekennzeichnet, dass** die Rechenvorrichtung (40) weiterhin für das Folgende programmiert ist:
Bestimmen (114), ob sich die mindestens eine Messung jedes Sensors von der mindestens einen Messung der anderen Sensoren der Mehrzahl von Sensoren (21-24) um weniger als einen vorbestimmten Grenzwert unterscheidet; und
Senden eines Befehls zum Beginnen einer Kalibrierung an die Mehrzahl von Sensoren (21, 24), wenn eine Differenz zwischen der mindestens einen Messung eines der Sensoren (21-24) und der mindestens einen Messung des mindestens einen anderen Sensors (21-24) gleich dem oder größer als der vorbestimmte Grenzwert ist.

12. System (5) nach Anspruch 11, wobei die Rechenvorrichtung (40) programmiert ist, um zu bestimmen (114), ob sich die mindestens eine Messung jedes Sensors von der mindestens einen Messung der anderen Sensoren der Mehrzahl von Sensoren (21-24) um weniger als den vorbestimmten Grenzwert unterscheidet, indem das Folgende erfolgt:
Projizieren (118) von Ausrichtungen, die zu der mindestens einen Messung jedes Sensors der Mehrzahl von Sensoren (21-24) gehören, auf eine horizontale Ebene, wodurch entsprechende Vektoren bereitgestellt werden;
Berechnen (119) eines Winkels zwischen jedem Paar zugehöriger Vektoren; und
Bestimmen (120), dass die Differenzen zwischen der mindestens einen Messung der Mehrzahl von Sensoren (21-24) kleiner als der vorbestimmte Grenzwert sind, falls jeder berechnete Winkel kleiner als der vorbestimmte Grenzwert ist.

13. System (5) nach Anspruch 11, wobei die von der Rechenvorrichtung (40) von jedem Sensor der Mehrzahl von Sensoren (21-24) empfangene mindestens eine Messung ein dreidimensionaler Magnetfeldvektor ist; und wobei die Rechenvorrichtung (40) programmiert ist, um zu bestimmen (114), ob sich die mindestens eine Messung jedes Sensors von der mindestens einen Messung der anderen Sensoren der Mehrzahl von Sensoren (21-24) um weniger als den vorbestimmten Grenzwert unterscheidet, indem das Folgende erfolgt:
Berechnen (119) eines Winkels zwischen jedem Paar zugehöriger dreidimensionaler Magnetfeldvektoren; und
Bestimmen (120), dass die Differenzen zwischen der mindestens einen Messung der Mehrzahl von Sensoren (21-24) kleiner als der vorbestimmte Grenzwert sind, falls jeder berechnete Winkel kleiner als der vorbestimmte Grenzwert ist.

14. System (5) nach Anspruch 11, wobei die von der Rechenvorrichtung (40) von jedem Sensor der Mehrzahl von Sensoren (21-24) empfangene mindestens eine Messung ein dreidimensionaler Magnetfeldvektor ist; und wobei die Rechenvorrichtung (40) weiterhin programmiert ist, um zu bestimmen (114), ob sich die mindestens eine Messung jedes Sensors von der mindestens einen Messung der anderen Sensoren der Mehrzahl von Sensoren (21-24) um weniger als den vorbestimmten Grenzwert unterscheidet, indem das Folgende erfolgt:
Berechnen (119) eines euklidischen Abstands zwischen jedem Paar zugehöriger dreidimensionaler Magnetfeldvektoren; und
Bestimmen (120), dass die Differenzen zwischen den Messungen der Mehrzahl von Sensoren (21-24) kleiner als der vorbestimmte Grenzwert sind, falls der euklidische Abstand kleiner als der vorbestimmte Grenzwert ist.

15. System (5) nach mindestens einem der Ansprüche 11-14, weiterhin mit der Mehrzahl von Sensoren (21-24), wobei jeder Sensor mindestens einen Prozessor aufweist, der zum Anwenden einer Sensorfusionsverarbeitung auf ein durch das Magnetometer (31) erfasste Magnetfeld und mindestens eine oder mehrere Messungen des Gyroskops (32) und des Beschleunigungsmessers (33) programmiert ist, wodurch die mindestens eine Messung bereitgestellt wird.

## Revendications

1. Procédé (100) pour étalonner une pluralité de capteurs (21-24) comprenant chacun un magnétomètre (31), un gyroscope (32) et un accéléromètre (33), le procédé comprenant les étapes consistant à :
fournir (111) un premier dispositif (10) comprenant au moins une cavité (15-18) adaptée pour l'introduction d'un ou plusieurs capteurs (21-24), ladite au moins une cavité étant dimensionnée de telle sorte que le ou les capteurs tiennent à l'intérieur lorsque les capteurs sont introduits avec une orientation particulière ;
introduire (112) chaque capteur de la pluralité de capteurs (21-24) dans le premier dispositif (10) ;
transmettre (113) à un appareil de calcul (40) par chaque capteur de la pluralité de capteurs (21-24) une première mesure correspondant au magnétomètre respectif (31) ;
**caractérisé par** les étapes consistant à :
déterminer (114), par l'appareil de calcul (40), si les différences entre la première mesure de chaque capteur et la première mesure des autres capteurs de la pluralité de capteurs (21-24) sont inférieures à un seuil prédéterminé ; et
si au moins l'une des différences entre les premières mesures est égale ou supérieure au seuil prédéterminé, étalonner (115) la pluralité de capteurs (21-24) en faisant tourner le premier dispositif (10) ou un second dispositif (10) avec la pluralité de capteurs (21-24) introduite à l'intérieur, le second dispositif (10) comprenant au moins une cavité (15-18) adaptée pour l'introduction d'un ou plusieurs capteurs (21-24).

2. Procédé (100) selon la revendication 1, dans lequel l'étape consistant à étalonner (115) la pluralité de capteurs (21-24) en faisant tourner le premier dispositif (10) ou le second dispositif (10) avec la pluralité de capteurs (21-24) introduite à l'intérieur comprend les étapes consistant à :
transmettre une instruction de début d'étalonnage par l'appareil de calcul (40) à chaque capteur de la pluralité de capteurs (21-24) ; et
faire tourner (115) le premier dispositif (10) ou le second dispositif (10) avec la pluralité de capteurs (21-24) introduite à l'intérieur selon une procédure d'étalonnage prédéterminée.

3. Procédé (100) selon l'une quelconque des revendications précédentes, dans lequel l'étape consistant à étalonner (115) la pluralité de capteurs (21-24) si au moins l'une des différences entre les premières mesures est égale ou supérieure au seuil prédéterminé, en faisant tourner le premier dispositif (10) ou le second dispositif (10) avec la pluralité de capteurs (21-24) introduite à l'intérieur, est exécutée jusqu'à ce que les différences déterminées entre des secondes mesures correspondantes au magnétomètre (31) de chaque capteur soient inférieures au seuil prédéterminé ; et dans lequel le procédé comprend en outre les étapes consistant à :
transmettre à l'appareil de calcul (40) par chaque capteur de la pluralité de capteurs (21-24) la seconde mesure correspondant au magnétomètre respectif (31) ; et
déterminer (115) par l'appareil de calcul (40) si les différences entre la seconde mesure de chaque capteur et la seconde mesure des autres capteurs de la pluralité de capteurs (21-24) sont inférieures au seuil prédéterminé.

4. Procédé (100) selon la revendication 3, dans lequel l'étape consistant à étalonner (115) la pluralité de capteurs (21-24), en faisant tourner le premier dispositif (10) ou le second dispositif (10) avec la pluralité de capteurs (21-24) introduite à l'intérieur, comprend en outre la répétition de l'étape consistant à étalonner (115) si au moins une des différences entre les secondes mesures de la pluralité de capteurs (21-24) est égale ou supérieure au seuil prédéterminé.

5. Procédé (100) selon l'une quelconque des revendications précédentes, dans lequel chaque étape consistant à déterminer (114) si les différences entre une mesure correspondant au magnétomètre (31) respectif de chaque capteur et une mesure correspondant au magnétomètre (31) respectif des autres capteurs de la pluralité de capteurs (21-24) sont inférieures au seuil prédéterminé comprend les étapes consistant à :
pour chaque capteur de la pluralité de capteurs (21-24), projeter (118) sur un plan horizontal une orientation correspondant à la mesure du capteur en fournissant ainsi un vecteur correspondant ;
calculer (119) un angle entre chaque paire de vecteurs correspondants ; et
déterminer (120) que les différences entre les mesures de la pluralité de capteurs (21-24) sont inférieures au seuil prédéterminé si chaque angle calculé est inférieur au seuil prédéterminé.

6. Procédé (100) selon l'une quelconque des revendications 1 à 4, dans lequel chaque étape consistant à déterminer (114) si les différences entre une mesure correspondant au magnétomètre (31) respectif de chaque capteur et une mesure correspondant au magnétomètre (31) respectif des autres capteurs de la pluralité de capteurs (21-24) sont inférieures au seuil prédéterminé, comprend les étapes consistant à :
pour chaque capteur de la pluralité de capteurs (21-24), projeter (118) sur un plan horizontal une orientation correspondant à la mesure du capteur, fournissant ainsi un vecteur correspondant ;
calculer (119) un angle entre chaque paire de vecteurs correspondants ;
comparer (121) chaque vecteur correspondant avec d'autres vecteurs correspondants afin de déterminer si un ou plusieurs vecteurs correspondants ont une différence d'angle supérieure à 90°; et
déterminer (120) que les différences entre les mesures de la pluralité de capteurs (21-24) sont inférieures au seuil prédéterminé si :
chaque angle calculé ayant une différence d'angle inférieure ou égale à 90° est inférieur au seuil prédéterminé ; et
pour chaque angle calculé ayant une différence d'angle supérieure à 90°, un résultat de 180° moins l'angle calculé est inférieur au seuil prédéterminé.

7. Procédé (100) selon l'une quelconque des revendications 1 à 4, dans lequel les mesures transmises (113) de chaque capteur de la pluralité de capteurs (21-24) à l'appareil de calcul (40) sont des vecteurs de champ magnétique tridimensionnels.

8. Procédé (100) selon la revendication 7, dans lequel chaque étape consistant à déterminer (114) si les différences entre une mesure correspondant au magnétomètre respectif (31) de chaque capteur et une mesure correspondant au magnétomètre respectif (31) des autres capteurs de la pluralité de capteurs (21-24) sont inférieures au seuil prédéterminé comprend les étapes consistant à :
calculer (125) un angle entre chaque paire de vecteurs de champ magnétique tridimensionnel correspondants ; et
déterminer (126) que les différences entre les mesures de la pluralité de capteurs (21-24) sont inférieures au seuil prédéterminé si chaque angle calculé est inférieur au seuil prédéterminé.

9. Procédé (100) selon la revendication 7, dans lequel chaque étape consistant à déterminer (114) si les différences entre une mesure correspondant au magnétomètre respectif (31) de chaque capteur et une mesure correspondant au magnétomètre respectif (31) des autres capteurs de la pluralité de capteurs (21-24) sont inférieures au seuil prédéterminé comprend les étapes consistant à :
calculer (127) une distance euclidienne entre chaque paire de vecteurs de champ magnétique tridimensionnel correspondants ; et
déterminer (128) que les différences entre les mesures de la pluralité de capteurs (21-24) sont inférieures au seuil prédéterminé si chaque distance euclidienne est inférieure au seuil prédéterminé.

10. Procédé (100) selon l'une quelconque des revendications précédentes, dans lequel les mesures transmises (113) par chaque capteur de la pluralité de capteurs (21-24) à l'appareil de calcul (40) sont fournies par les capteurs (21-24) en combinant, avec un processus de fusion de capteurs, un champ magnétique détecté par le magnétomètre (31) respectif avec au moins une ou plusieurs mesures du gyroscope (32) et de l'accéléromètre (33) respectifs.

11. Système (5) pour étalonner une pluralité de capteurs (21-24) comprenant chacun un magnétomètre (31), un gyroscope (32) et un accéléromètre (33), le système comprenant :
un dispositif (10) comprenant au moins une cavité (15-18) adaptée pour l'introduction d'un ou plusieurs capteurs (21-24) ; et
un appareil de calcul (40) comprenant au moins un processeur (42), au moins une mémoire (44) et des moyens (46) pour transmettre et recevoir des données, l'appareil de calcul (40) étant programmé pour :
recevoir, de chaque capteur de la pluralité de capteurs (21-24), au moins une mesure correspondant au magnétomètre respectif (31) ;
**caractérisé en ce que** l'appareil de calcul (40) est en outre programmé pour :
déterminer (114) si ladite au moins une mesure de chaque capteur diffère de ladite au moins une mesure des autres capteurs de la pluralité de capteurs (21-24) de moins d'un seuil prédéterminé ; et
transmettre des instructions de début d'étalonnage à la pluralité de capteurs (21-24) lorsqu'une différence entre ladite au moins une mesure de l'un des capteurs (21-24) et ladite au moins une mesure d'au moins un autre des capteurs (21-24) est égale ou supérieure au seuil prédéterminé.

12. Système (5) selon la revendication 11, dans lequel l'appareil de calcul (40) est programmé pour déterminer (114) si ladite au moins une mesure de chaque capteur diffère de ladite au moins une mesure des autres capteurs de la pluralité de capteurs (21-24) de moins que le seuil prédéterminé en :
projetant (118) sur un plan horizontal des orientations correspondant à ladite au moins une mesure de chaque capteur de la pluralité de capteurs (21-24), fournissant ainsi des vecteurs correspondants ;
calculant (119) un angle entre chaque paire de vecteurs correspondants ; et
déterminant (120) que les différences entre ladite au moins une mesure de la pluralité de capteurs (21-24) sont inférieures au seuil prédéterminé si chaque angle calculé est inférieur au seuil prédéterminé.

13. Système (5) selon la revendication 11, dans lequel ladite au moins une mesure reçue par l'appareil de calcul (40) provenant de chaque capteur de la pluralité de capteurs (21-24) est un vecteur de champ magnétique tridimensionnel ; et dans lequel l'appareil de calcul (40) est programmé pour déterminer (114) si ladite au moins une mesure de chaque capteur diffère de ladite au moins une mesure des autres capteurs de la pluralité de capteurs (21-24) de moins que le seuil prédéterminé en :
calculant (119) un angle entre chaque paire de vecteurs de champ magnétique tridimensionnel correspondants ; et
déterminant (120) que les différences entre ladite au moins une mesure de la pluralité de capteurs (21-24) sont inférieures au seuil prédéterminé si chaque angle calculé est inférieur au seuil prédéterminé.

14. Système (5) selon la revendication 11, dans lequel ladite au moins une mesure reçue par l'appareil de calcul (40) provenant de chaque capteur de la pluralité de capteurs (21-24) est un vecteur de champ magnétique tridimensionnel ; et dans lequel l'appareil de calcul (40) est en outre programmé pour déterminer (114) si ladite au moins une mesure de chaque capteur diffère de ladite au moins une mesure des autres capteurs de la pluralité de capteurs (21-24) de moins que le seuil prédéterminé en :
calculant (119) une distance euclidienne entre chaque paire de vecteurs de champ magnétique tridimensionnel correspondants ; et
déterminant (120) que les différences entre ladite au moins une mesure de la pluralité de capteurs (21-24) sont inférieures au seuil prédéterminé si chaque distance euclidienne est inférieure au seuil prédéterminé.

15. Système (5) selon l'une quelconque des revendications 11-14, comprenant en outre la pluralité de capteurs (21-24), chaque capteur comprenant en outre au moins un processeur programmé pour appliquer un processus de fusion de capteurs à un champ magnétique détecté par le magnétomètre (31) et au moins une ou plusieurs mesures du gyroscope (32) et de l'accéléromètre (33), fournissant ainsi ladite au moins une mesure.
